# EUROPÄISCHE PATENTANMELDUNG

(11) **EP 1 762 432 A2**
(43) Veröffentlichungstag der Anmeldung: **14.03.2007**
(21) Anmeldenummer: 06018639.2
(22) Anmeldetag: 06.09.2006
(51) Int. Cl.: B60Q 1/30, F21S 8/10

(54) **Heckleuchtenanordnung**

(30) Priorität: 12.09.2005 DE 102005043510; 14.01.2006 DE 102006001947
(71) Anmelder: KOMPLED GmbH & Co. KG, 89081 Ulm (DE)
(72) Erfinder: Koch, Josef, 89081 Ulm (DE)
(74) Vertreter: Weber, Gerhard

(57) **Zusammenfassung**

Für eine Heckleuchtenanordnung, insbesondere eines Nutzfahrzeugs, mit leistungsstarken Lichtquellen, insbesondere für Rückfahrscheinwerferfunktion und/oder Nebelschlussleuchtenfunktion, wird ein Leuchtengehäuse aus gefülltem Kunststoff mit erhöhtem Wärmeleitwert und/oder mit einer zusätzlichen Arbeitsleuchtenfunktion beschrieben.

## Beschreibung

Die Erfindung betrifft eine Heckleuchtenanordnung, insbesondere für Nutzfahrzeuge.

Fahrzeugaußenleuchten an Nutzfahrzeugen sind typischerweise als eigenständige geschlossene Leuchtengehäuse ausgeführt und, im Unterschied zu Personenkraftwagen mit in Karrosserieöffnungen integrierte Fahrzeugleuchten, so an dem Nutzfahrzeug befestigt, dass die Gehäuseaußenfläche überwiegend oder vollständig Umgebungseinflüssen ausgesetzt ist. Eine Fahrzeugaußenleuchte in Form einer Seitenmarkierungsleuchte ist z. B. aus der DE 203 04 930 U1 bekannt. Das Leuchtengehäuse besteht aus einer topfförmigen transparenten Lichtscheibe und einem Bodenteil, welche entlang einer Gehäusefuge zusammengefügt sind. Eine Lichtquellenanordnung ist mit einem durch eine Öffnung im Bodenteil geführten Kabel in einer dem Innenraum des Gehäusebodens zugewandten Mulde in Polyurethan eingegossen. An die Gehäusefuge ist ein Kunststoffmaterial angespritzt.

Der Erfindung liegt die Aufgabe zugrunde, eine Fahrzeug-Heckleuchtenanordnung anzugeben, welche insbesondere auch mit leistungsstarken Lichtquellen betreibbar ist.

Erfindungsgemäße Lösungen sind in den unabhängigen Ansprüchen beschrieben. Die abhängigen Ansprüche enthalten vorteilhafte Ausgestaltungen und Weiterbildungen der Erfindung.

Die Verwendung eines gefüllten Kunststoffes mit erhöhter Wärmeleitfähigkeit für ein als Spritzgussteil ausgeführtes Bodenteil ist trotz der höheren Kosten für das gefüllte Kunststoffmaterial gegenüber einem ungefüllten Kunststoff von besonderem Vorteil, da die weitgehende Formfreiheit eines Spritzgussteils für das Bodenteil vorteilhaft verbunden ist mit einer guten Wärmeabfuhr, so dass besondere zusätzliche Bauteile und Maßnahmen für die Abfuhr der in den Lichtquellen als Wärme auftretenden Verlustleistung entbehrlich sind. Eine gute Wärmeableitung ist sowohl für die Lichtausbeute in den Leuchtdioden als auch für deren Lebensdauer von wesentlicher Bedeutung.

Das Bodenteil ist vorteilhafterweise topfförmig ausgebildet. Vorzugsweise ist das Leuchtengehäuse nur durch die Lichtscheibe und das Bodenteil gebildet, welche entlang einer umlaufenden Gehäusefuge zusammengefügt sind, wobei die Gehäusefuge vorteilhafterweise durch ein einen Dichtkörper bildendes angespritztes Dichtmaterial, vorzugsweise ein thermoplastisches Elastomer abgedichtet ist.

Das spritzgussfähige Kunststoff-Grundmaterial kann beispielsweise ein Polyamid sein. Als Füllkörper sind insbesondere mineralische, keramische, glasartige oder metallische Körper geeignet. Gefüllte Kunststoffe mit spritzgussfähigem Kunststoff-Grundmaterial sind an sich bekannt. Der Wärmeleitwert des gefüllten Kunststoffmaterials des Bodenteils beträgt vorteilhafterweise wenigstens 2,5 WK/m, insbesondere wenigstens 4 WK/m.

Vorteilhafterweise sind an der Außenseite der von dem Bodenteil gebildeten und der Lichtaustrittsfläche der Lichtscheibe abgewandten Rückwand des Leuchtengehäuses von der Außenfläche der Rückwand abstehende Vorsprünge ausgebildet, wobei die zwischen den Vorsprüngen freien Räume auch als Vertiefungen betrachtet werden können und Kanäle für das Durchströmen von Luft bilden können. Die durch solche Kanäle strömende Luft erzeugt eine Konvektionskühlung an der Außenseite der Rückwand. Die Vorsprünge können insbesondere als parallele längliche Stege ausgeführt sein.

Die dem Innenraum des Leuchtengehäuses abgewandten Enden einiger, insbesondere der meisten oder vorzugsweise aller Vorsprünge sind vorteilhafterweise abgeflacht, wobei die Abflachungen vorteilhafterweise in einer gemeinsamen Ebene liegen. Die Abflachungen der Vorsprünge sind im montierten Zustand gegen eine metallische Montagefläche des Fahrzeugs, z. B. eines Unterfahrschutzes, eines metallischen Kotflügels einer speziell zur Wärmeabfuhr eingesetzten Metallplatte etc. gedrückt, wobei vorteilhafterweise durch die Formnachgiebigkeit des Kunststoffmaterials des Bodenteils eine gute flächige Anlage der Abflachungen der Vorsprünge an der Montagefläche und damit ein großflächiger Wärmeübergang gegeben ist. Eine Wärmeabfuhr kann damit vorteilhafterweise durch die Kombination der Konvektion von Luft zwischen den Vorsprüngen und Wärmeübergang auf die Montagefläche erfolgen.

Die Verspannung der Abflachungen gegen die Montagefläche erfolgt vorteilhafterweise mittels in dem Bodenteil, insbesondere der Rückwand montierten Befestigungselementen, insbesondere Schrauben, welche vorzugsweise zugleich zur Befestigung des Leuchtengehäuses am Fahrzeug dienen.

Die Summe der Flächen der in der gemeinsamen Ebene liegenden Abflachungen an den Enden der Vorsprünge beträgt vorteilhafterweise wenigstens 30 %, insbesondere wenigstens 35 %, vorzugsweise wenigstens 40 % der Fläche der Rückwand, wobei unter der Fläche der Rückwand dabei die Projektionsfläche der Rückwand auf die genannte gemeinsame Ebene verstanden sei. Die Breite der Abflachungen der Vorsprünge in der gemeinsamen Ebene beträgt vorteilhafterweise wenigstens 30 %, insbesondere wenigstens 45 %, vorzugsweise wenigstens 60 % der Höhe der Vorsprünge über die die Rückwand hinaus bzw. der Tiefe der Vertiefungen zwischen den Vorsprüngen.

Die Verwendung eines gefüllten Kunststoffs mit erhöhter Wärmeleitfähigkeit ist insbesondere von Vorteil für Leuchten mit überdurchschnittlich leistungsstarken Leuchtdioden, wie sie z. B. für die Funktionen einer Nebelschlussleuchte und/oder eines Rückfahrscheinwerfers und/oder einer Heck-Arbeitsleuchte vorteilhaft sind. Durch eine gute Wärmeabfuhr kann zum einen die Betriebstemperatur der Leuchtdioden niedrig gehalten werden, zum anderen wird vermieden, dass durch hohe Temperaturen im Innenraum des Leuchtengehäuses ein hoher Überdruck oder hohe Druckschwankungen entstehen, welche nachteilig für die Abdichtung des Gehäuses sind.

Für eine Arbeitsleuchte, welche typischerweise am Heck des Fahrzeugs angeordnet ist, ist eine Ausführung mit einem Leuchtengehäuse und einem innerhalb des Leuchtengehäuses angeordneten Sensorschalter, welcher berührungslos durch das Gehäuse, insbesondere durch die Lichtscheibe hindurch betätigbar ist, von besonderem Vorteil. Die Arbeitsleuchte ist dadurch an Ort und Stelle durch den Benutzer nach Bedarf einschaltbar, ohne dass ein separater außenliegender Schalter und/oder eine weitere Gehäuseöffnung für einen Schalter vorgesehen sein müsste. Der Sensorschalter kann insbesondere mit Leuchtdioden für die Leuchtenfunktion der Arbeitsleuchte auf einer gemeinsamen Platine angeordnet sein. Durch die Verwendung von Leuchtdioden für die Arbeitsleuchte ist die Gruppierung der Leuchtdioden um den für den Sensorschalter benutzten Flächenbereich auf besonders einfache Weise möglich.

Der Sensorschalter ist vorteilhafterweise annähernd in der Flächenmitte der Leuchtscheibe hinter dieser angeordnet. Der Sensorschalter kann durch ein spezielles Betätigungselement, z. B. einen Magneten betätigbar sein. In bevorzugter Ausführung ist der Sensorschalter durch Auflegen eines Fingers auf die Lichtscheibe betätigbar. Vorteilhafterweise weist die Lichtscheibe im Bereich des Sensorschalters eine tastbare Struktur auf. Die Lichtscheibe kann vorteilhafterweise im Bereich des Sensorschalters mit geringer Wandstärke ausgeführt sein. Die Lichtscheibe kann im Bereich des Sensorschalters insbesondere eine muldenförmige Vertiefung aufweisen. Der Sensorschalter kann insbesondere ein durch Auflegen eines Fingers auf die Lichtscheibe in seinem Kapazitätswert veränderbares kapazitives Element enthalten.

Für eine heckseitige Arbeitsleuchte kann vorteilhafterweise ein Rückfahrscheinwerfer und/oder eine Nebelschlussleuchte eingesetzt werden, wobei ein separater Schalter für das Einschalten der Arbeitsleuchte vorgesehen sein kann, insbesondere der vorstehend erwähnte Sensorschalter innerhalb eines Leuchtengehäuses. Für die Arbeitsleuchtenfunktion ist über den Schalter zu einer für eine übliche Beleuchtungsfunktion bereits vorhandene Basisleuchte, insbesondere dem Rückfahrscheinwerfer oder der Nebelschlussleuchte, eine weitere Lichtquelle am Fahrzeugheck zuschaltbar. Unter Arbeitsleuchte sei dabei eine leuchte oder Leuchtenkombination zu verstehen, welche einen Nahbereich beim Heck des Fahrzeugs beleuchtet, wobei mehrere Leuchten einer Leuchtenkombination vorzugsweise überlappende Beleuchtungsbereiche aufweisen. Vorzugsweise umfasst die Arbeitsleuchte den Rückfahrscheinwerfer als eine Basisleuchte, welchem über den Schalter eine weitere Lichtquelle, insbesondere die Nebelschlussleuchte als weitere Lichtquelle, hinzuschaltbar ist. Insbesondere kann die weitere Lichtquelle über die individuelle Versorgungsleitung der Basisleuchte mit elektrischer Leistung versorgbar sein. Überraschenderweise erweist sich ein gleichzeitiger Betrieb von Rückfahrscheinwerfer und Nebelschlussleuchte, insbesondere bei geringem gegenseitigem Abstand der beiden als Arbeitslicht für den Benutzer besonders angenehm. Der Effekt kann auch erreicht werden, wenn zu Rückfahrscheinwerfer oder zu Nebelschlussleuchte für die Arbeitsleuchtenfunktion eine Lichtquelle mit zu der jeweils anderen Leuchtenfunktion ähnlicher spektraler Zusammensetzung hinzugeschaltet wird.

Bei einer Heckleuchtenanordnung, welche einen weißes Licht abgebenden Rückfahrscheinwerfer und ein rotes Licht abgebende Nebelschlussleuchte enthält, sind vorteilhafterweise für beide Leuchtenfunktionen Leuchtdioden als Lichtquellen eingesetzt. Die Leuchtdioden für beide Leuchtenfunktionen sind vorteilhafterweise in einem gemeinsamen Leuchtengehäuse mit einer gemeinsamen transparenten Lichtscheibe angeordnet. Die Lichtscheibe ist vorteilhafterweise unter Verwendung rot strahlender Leuchtdioden für die Nebelschlussleuchte einheitlich durchgehend farblos transparent.

Die Leuchtdioden für den Rückfahrscheinwerfer einerseits und die Leuchtdioden für die Nebelschlussleuchte andererseits nehmen vorteilhafterweise getrennte, nicht überlappende Flächenbereiche hinter der Lichtscheibe ein. Vorteilhafterweise sind die Leuchtdioden für beide Leuchtenfunktionen auf einer gemeinsamen Schaltungsplatine, welche auch noch weitere elektronische Bauteile enthalten kann, untergebracht.

Für die Verschaltung der Arbeitsleuchte ist in vorteilhafter Ausführung vorgesehen, dass hierzu der Rückfahrscheinwerfer durch Einlegen des Rückwärtsgangs im Fahrzeug eingeschaltet sein muss und über den Sensorschalter die zusätzliche Lichtquelle, insbesondere rote Leuchtdioden, vorzugsweise die Leuchtdiode der Nebelschlussleuchte zugeschaltet werden. Die Zuschaltung der roten Leuchtdioden für die Funktion der Arbeitsleuchte wird dabei vorzugsweise mit Ausschalten des Rückfahrscheinwerfers wieder aufgehoben und die zusätzliche Lichtquelle wird in den ausgeschalteten Zustand zurückversetzt, so dass bei erneutem Einlegen des Rückwärtsgangs nur der Rückfahrscheinwerfer eingeschaltet wird.

In anderer vorteilhafter Ausführung kann der Schalter auch als bistabiler Umschalter ausgeführt sein, welcher eine vom Benutzer gewählte Schalterstellung auch nach dem Ausschalten des Rückfahrscheinwerfers, insbesondere auch ohne Spannungsversorgung, beibehält und nach dem Wiedereinschalten des Rückfahrscheinwerfers auch die weitere Lichtquelle, vorzugsweise die Nebelschlussleuchte einschaltet, soweit diese nicht bereits eingeschaltet ist.

Die Erfindung ist nachfolgend anhand bevorzugter Ausführungsbeispiele unter Bezugnahme auf die Abbildungen noch eingehend veranschaulicht. Dabei zeigt:
- Fig. 1: eine Zusammenstellung mehrerer Elemente einer Heckleuchtenanordnung,
- Fig. 2: eine zusammengesetzte Heckleuchtenanordnung nach Fig. 1 in geschnittener Ansicht,

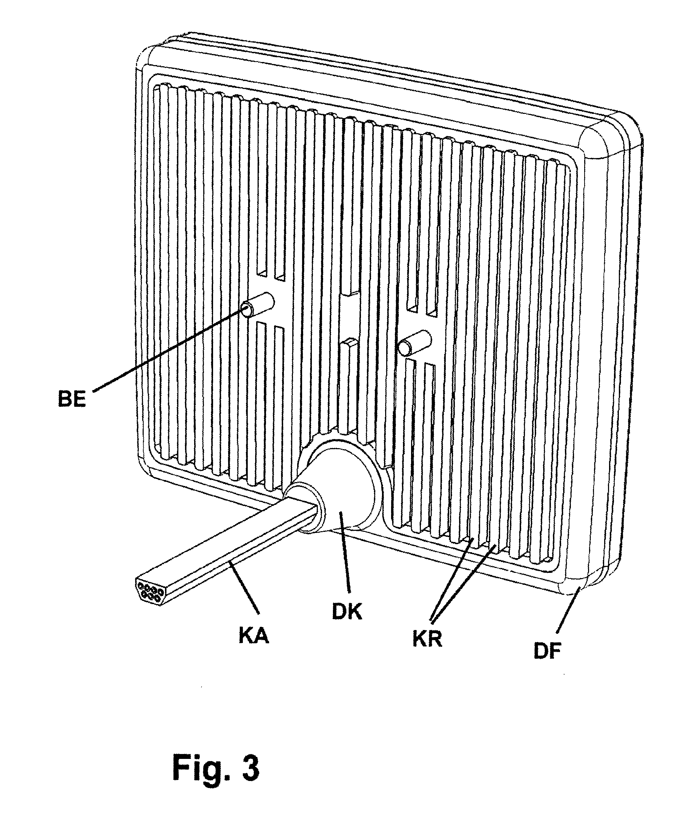

- Fig. 3: eine Rückseite der Heckleuchtenanordnung nach Fig. 2,
- Fig. 4: einen vergrößerten Schnitt durch eine Heckleuchtenanordnung nach Fig. 2,
- Fig. 5: eine Schaltungsskizze für eine Arbeitsleuchte.

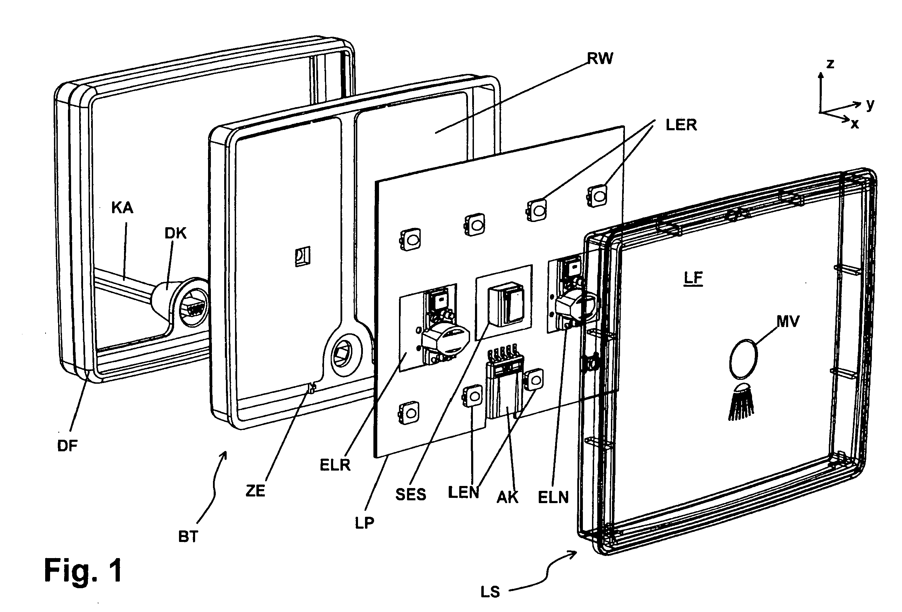

Die Heckleuchtenanordnung nach Fig. 1 weist ein zweiteiliges Gehäuse mit einer transparenten Lichtscheibe LS und einem topfförmigen Bodenteil BT auf, welche in x-Richtung des mit eingezeichneten rechtwinkligen Koordinatensystems zusammenfügbar sind und dabei eine umlaufende Gehäusefuge ausbilden und einen Innenraum allseitig umschließen.

Lichtscheibe einerseits und Bodenteil andererseits sind vorteilhafterweise aus unterschiedlichen Materialien hergestellt, insbesondere als Spritzgussteile aus Kunststoff. In vorteilhafter Ausführung kann das Bodenteil insbesondere aus einem sogenannten gefüllten Kunststoff bestehen, bei welchem einer Kunststoff-Grundmasse, welche auch aus einem Gemisch von mehreren Kunststoffen bestehen kann, Füllstoffe zugefügt sind, welch eine gegenüber der Grundmasse wesentlich höhere spezifische Wärmeleitfähigkeit besitzen. Die Kunststoff-Grundmasse kann insbesondere ein thermoplastisches oder duroplastisches, spritzgussfähiges Material sein. Füllstoffe sind typischerweise feine keramische, glasartige oder metallische Festkörperpartikel, welche in die Grundmasse eingebettet sind. Das in dieser Weise gefüllte Kunststoffmaterial ist gleichfalls spritzgussfähig und weist im kalten verfestigten Zustand eine spezifische Wärmeleitfähigkeit auf, welche wesentlich höher, vorteilhafterweise wenigstens um den Faktor 4, insbesondere wenigstens um den Faktor 8 höher ist als die der Kunststoff-Grundmasse. Vorteilhafterweise ist der Faktor nicht größer als 20, wodurch vorteilhafterweise die mechanischen Eigenschaften des Grundmaterials weitgehend erhalten bleiben können. Gefüllte Kunststoffe sind an sich bekannt. Das Grundmaterial kann beispielsweise ein Polyamid sein. Beispielsweise kann ein Polyamid-Grundmaterial einen Wärmeleitwert typischerweise im Bereich 0,3 - 0,5 WK/m besitzen und der gefüllte Kunststoff mit nichtmetallischen Füllstoffen einen Wärmeleitwert von wenigstens 2,5 WK/m, insbesondere wenigstens 4 WK/m. Mit höherem Füllgrad und/oder metallischen Füllstoffen können auch gefüllte Kunststoffe mit deutlich höherem Wärmeleitwert erzeugt werden.

Die Verwendung eines gefüllten Kunststoffes als Material für das Bodenteil des Leuchtengehäuses einer Fahrzeugaußenleuchte ist von besonderem Vorteil, da zum einen das Bodenteil im Kunststoff-Spritzgussverfahren herstellbar ist und als einstückiges Bauteil weitgehend beliebige Form besitzen kann. Zum anderen ergibt sich eine gegenüber Gehäusen aus ungefüllten Kunststoffen erheblich verbesserte Ableitung der beim Betrieb der Lichtquellen im Innenraum anfallenden Wärme. Die verbesserte Wärmeableitung ermöglicht vorteilhafterweise den Einsatz leistungsstarker elektronischer Lichtquellen, insbesondere Leuchtdioden, welche durch die gute Wärmeableitung bei günstig niedrigen Sperrschichttemperaturen und damit mit hoher Lichtausbeute und langer Lebensdauer betrieben werden können. Die gute Wärmeableitung über das Material des Bodenteils hat ferner den Vorteil, dass die Temperaturschwankungen im Innenraum des Leuchtengehäuses gering bleiben. Damit sind auch die Druckschwankungen im Gehäuseinnenraum, welche einen Pumpeffekt an Gehäusefugen und Durchführungen verursachen können, niedrig und die Gefahr, dass Abdichtungen an Gehäusefugen und Durchführungen durch Wechselbeanspruchungen undicht werden und Feuchtigkeit in das Gehäuseinnere eindringt, gering.

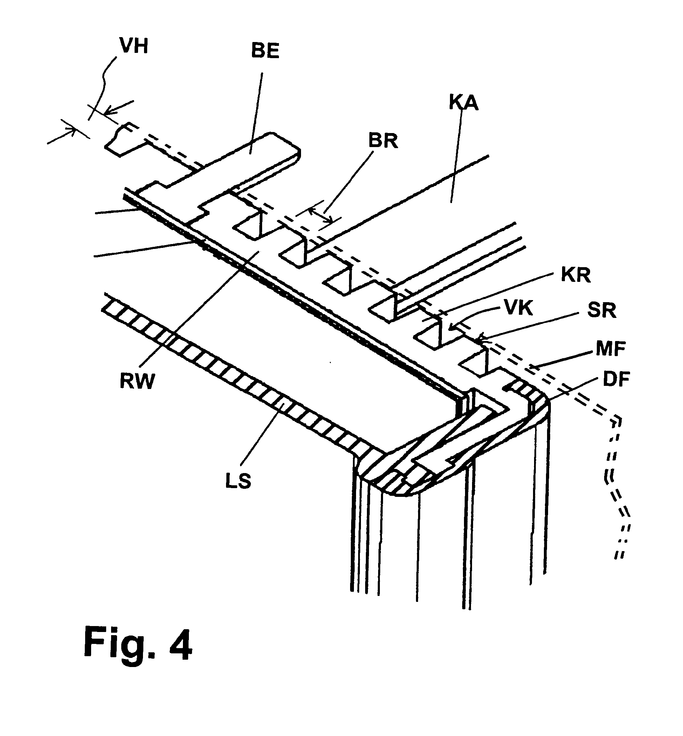

Durch die Ausführung des Bodenteils zumindest teilweise, insbesondere überwiegend, vorzugsweise vollständig aus gefülltem Kunststoff steht eine große Außenfläche zur Abgabe der aus dem Innenraum abgeleiteten Wärme an die Umgebungsluft und/oder an vorzugsweise metallische Befestigungsflächen des Fahrzeugs, an welchen die Leuchtenanordnung befestigt sein kann, zur Verfügung. Insbesondere zur Wärmeabgabe an die Umgebungsluft kann ein Teil der Außenfläche des Bodenteils mit einer Reliefstruktur, z. B. in Form von Stegen in der Art von Kühlrippen versehen sein. Solche Stege bzw. Kühlrippen KR sind in der Rückseitenansicht eines Leuchtengehäuses nach Fig. 4 veranschaulicht. Im Gehäuseinnenraum können vorteilhafterweise Mittel zur Ableitung von Verlustwärme von den Lichtquellen, insbesondere flächige wärmespreizende Elemente vorgesehen sein.

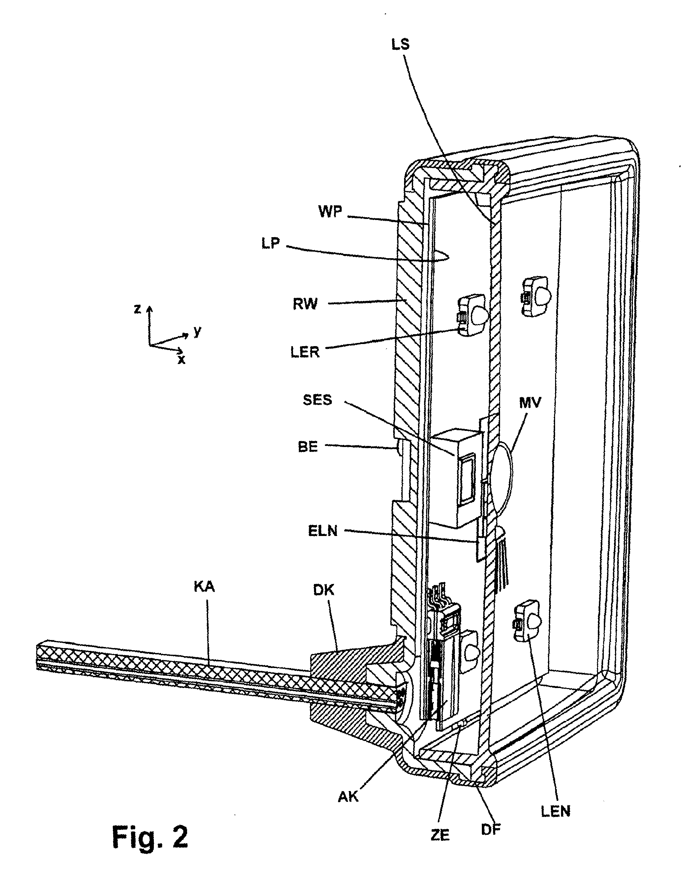

In dem in Fig. 1 skizzierten Beispiel sind auf einer Leiterplatte LP zwei Reihen von leistungsstarken einzelnen Leuchtdioden LER bzw. LEN angeordnet, welche einheitlich einer Beleuchtungsfunktion oder in bevorzugtem Beispiel gruppenweise mehreren unabhängigen Beleuchtungsfunktionen zugeordnet sein können, beispielsweise die Diodengruppe LEN der Leuchtenfunktion der Nebelschlussleuchte und die Diodengruppe LER der Leuchtenfunktion des Rückfahrscheinwerfers. Auf der Leiterplatte LP sind auch Versorgungsschaltungen als elektronische Schaltungen ELR, ELN zur Ansteuerung der Leuchtdioden LER, LEN angeordnet, über welche z. B. ein Konstantstrom oder eine Konstantspannung für die Dioden vorgegeben sein kann und/oder welche für einen hohen Wirkungsgrad DC-Wandler mit Übertragern enthalten können. Ferner ist auf der Leiterplatte ein Anschlussklemmblock AK vorgesehen, über welchen Adern eines Anschlusskabels KA mit Leiterbahnen der Leiterplatte verbunden sind. Die vorteilhafterweise aus Isoliermaterial mit metallischen Leiterbahnen bestehende Leiterplatte LP ist vorteilhafterweise auf einer wärmespreizend wirkenden Trägerplatte WP, beispielsweise aus Aluminium angeordnet, welche vorteilhafterweise ihrerseits mit dem gefüllten Kunststoffmaterial des Bodenteils möglichst flächig in Kontakt stehen kann. auf der Leiterplatte LP ist weiter ein Sensorschalter SES vorgesehen. In der geschnittenen Ansicht nach Fig. 2 ist die Versorgungsschaltung ELN als durch die Lichtscheibe LS verdeckt dargestellt, um die muldenförmige Vertiefung MV in der Lichtscheibe besser zur Darstellung zu bringen.

Die Plattenanordnung mit Trägerplatte und Leiterplatte können über am Bodenteil angeformte Zentrierelemente ZE in der y-z-Ebene in definierter Position gehalten sein, was insbesondere beim Zusammenbau von Vorteil sein kann.

Die umlaufende Gehäusefuge GF zwischen Lichtscheibe und Bodenteil weist vorteilhafterweise nach Art einer Labyrinthdichtung im Querschnitt nach Fig. 2 unterschiedliche Ausrichtungen von gegenüberstehenden Fugenflächen auf. Die Gehäusefuge ist außen vollständig von einem Dichtungskörper DF umschlossen, welcher nach dem Zusammenfügen von Lichtscheibe und Bodenteil im Spritzgussverfahren aufgebracht ist. Der Dichtungskörper reicht vorteilhafterweise von der Gehäusefuge entlang der Außenfläche der Lichtscheibe bis zu einer Kante KL und/oder entlang der Außenfläche des Bodenteils zu einer Kante KB und umgreift diese Kante(n). Vorteilhafterweise ist nach der Kante KL bzw. KB noch eine Nut NL bzw. NB vorgesehen, in welche der Dichtungskörper DF eingreift. Durch Kante(n) und/oder Nute(n) ergibt sich eine lange Kontaktfläche und eine gute mechanische Verankerung des Dichtungskörpers an Lichtscheibe bzw. Bodenteil.

Das Leuchtengehäuse weist vorteilhafterweise in Haupt-Abstrahlrichtung x eine geringe Gehäusetiefe GT auf, welche vorteilhafterweise weniger als 50 mm, insbesondere weniger als 40 mm, vorzugsweise weniger als 35 mm beträgt.
Die den Innenraum entlang der Gehäusefuge umgebenden schmalen Seitenflächen des Gehäuses sind in x-Richtung vorteilhafterweise zu wenigstens 80 % der Flächentiefe FT in x-Richtung von dem Dichtungskörper DF bedeckt. Lichtscheibe und Bodenteil überdecken sich vorteilhafterweise in x-Richtung über wenigstens 30 % der Flächentiefe FT.

Das Bodenteil weist eine von der Gehäusefuge getrennte bzw. beabstandete Öffnung BO zur Durchführung eines mehradrigen Kabels KA auf. Der Spalt zwischen Kabel KA und Öffnung BO ist vorteilhafterweise durch einen an der Außenseite des Bodenteils um die Öffnung BO und an dem Kabelmantel des Kabels KA anliegenden weiteren Dichtungskörper DK abgedichtet, welcher vorteilhafterweise gleichfalls im Spritzgussverfahren an Kabel und Bodenteil angespritzt ist. Vorteilhafterweise ist der Dichtungskörper DK aus demselben Material wie der Dichtungskörper DF entlang der Gehäusefuge GF. Vorzugsweise sind der Dichtungskörper DK an der Kabeldurchführung und der Dichtungskörper DF entlang der Gehäusefuge als einstückiger Dichtungskörper miteinander verbunden. Vorteilhafterweise ist die Öffnung BO im Bodenteil in dessen Rückwandfläche angeordnet. Vorteilhafterweise ist die Position der Öffnung BO in der Rückwandfläche aus der Flächenmitte der Rückwand versetzt angeordnet und liegt vorzugsweise näher am Rand der Rückwandfläche als an deren Flächenmitte.

Der Dichtungskörper DF entlang der Gehäusefuge und/oder der Dichtungskörper DK an der Kabeldurchführung bestehen vorteilhafterweise aus einem spritzgussfähigen thermoplastischen Elastomer. Das thermoplastische Elastomer kann vorteilhafterweise haftvermittelnde Zusatzstoffe enthalten, welche auf die Materialien von Lichtscheibe und Bodenteil an der Gehäusefuge bzw. Kabelmantel und Bodenteil an der Kabeldurchführung abgestimmt sind. Derartige haftvermittelnde Zusatzstoffe für thermoplastische Elastomere sind an sich in großer Variation bekannt. Die Verwendung eines thermoplastischen Elastomers mit haftvermittelnden Zusatzstoffen ist für ein derart abgedichtetes Leuchtengehäuse von besonderem Vorteil, da die dauerhafte Elastizität des nach dem Spritzgussvorgang abgekühlten Dichtungskörper eine gute Abdichtung auch bei unterschiedlichem thermischem Verhalten der unterschiedlichen Materialien gewährleistet.

Fig. 4 zeigt anhand eines vergrößerten Ausschnitts durch ein Leuchtengehäuse ein vorteilhaftes Beispiel für die Gestaltung des Bodenteils BT, insbesondere dessen Rückwand-Außenseite.

Die Leiterplatte LP, auf welcher die Leuchtdioden und gegebenenfalls weitere elektronische Bauelemente angeordnet sind, ist auf einer Wärmespreizplatte WP angeordnet und kann insbesondere mit dieser verklebt sein. Die Wärmespreizplatte besteht aus einem gut wärmeleitenden Material, insbesondere Aluminium und verteilt die an den Leuchtdioden quasi punktuell anfallende Verlustwärme großflächig. Die Innenfläche der Rückwand RW ist weitgehend eben und die Wärmespreizplatte WP liegt in gutem Wärmekontakt an der Innenfläche der Rückwand an. Die Wärmespreizplatte kann mit der Innenfläche der Rückwand über eine gut wärmeleitende Schicht, z. B. einer Wärmeleitpaste verbunden und/oder verklebt sein.

Die Außenseite der Rückwand RW weist eine Reliefstruktur mit Vorsprüngen, z. B. in Form von Stegen KR nach Art von Kühlrippen und Vertiefungen VK zwischen den Stegen auf. Die Reliefstruktur ist vorteilhafterweise einstückig und materialhomogen mit der Rückwand ausgeführt. Die Vorsprünge sind an ihren von der Rückwand weg weisenden Enden vorteilhafterweise abgeflacht, wobei vorzugsweise die Abflachungen zumindest der meisten Vorsprünge in einer gemeinsamen Ebene ME liegen und bei Montage des Leuchtengehäuses an einer vorzugsweise metallischen ebenen Montagefläche flächig in wärmeleitendem Kontakt mit einer solchen Montagefläche stehen. Die Breite BR der Stege KR und vorzugsweise auch deren Abflachungen SR beträgt vorteilhafterweise wenigstens 35 %, insbesondere wenigstens 45 %, vorzugsweise wenigstens 60 % der Höhe VH der Vorsprünge in x-Richtung über die Rückwand hinaus. Die Summe der Flächen der an der Montageebene anliegenden Abflachungen beträgt vorteilhafterweise wenigstens 20 %, insbesondere wenigstens 30 %, vorzugsweise wenigstens 40 % der Projektionsfläche der Rückwand auf die Montagefläche, welche annähernd durch Breite GL und Höhe HL des Leuchtengehäuses gegeben ist.

Die Vertiefungen zwischen den Vorsprüngen bilden bei an der Montageebene anliegenden Abflachungen vorteilhafterweise Strömungskanäle für Umgebungsluft, welche Wärme entlang der Außenfläche der Rückwand und der Flanken der Stege aufnimmt. Durch die vorteilhafte Reliefgestaltung der Außenseite der Rückwand ergibt sich eine besonders effektive Abgabe der durch das gefüllte Kunststoffmaterial nach außen transportierten Verlustwärme an die durch die Vertiefungen strömende Umgebungsluft und an die Montagefläche.

Im Beispiel der Fig. 4 ragen Befestigungselemente BE, insbesondere Gewindeschrauben oder Gewindekopfbolzen, durch die Rückwand des Bodenteils hindurch nach außen. In anderer Ausführung können die Befestigungselemente in die Rückwand bei der Herstellung des Bodenteils im Spritzgussverfahren so in dieses eingegossen werden, dass die Innenfläche der Rückwand ununterbrochen durchgehend verläuft. Mittels der Befestigungselemente wird das Leuchtengehäuse an der Montagefläche befestigt und mit den Abflachungen der Stege gegen die Montagefläche verspannt.

In der Lichtdurchtrittsfläche LF der Lichtscheibe LS ist vorteilhafterweise in der Außenseite eine tastbare Reliefstruktur MV angebracht, welche in der y-z-Ebene im Bereich des Sensorschalters SES liegt und dem Benutzer das Auffinden der Stelle, an welcher zur Betätigung des Sensorschalters ein Finger auf die Lichtscheibe aufzulegen ist, erleichtert. Die tastbare Reliefstruktur kann eine muldenartige Vertiefung MV enthalten.

Vorteilhafterweise kann die Wandstärke der Lichtscheibe im Bereich des Sensorschalters reduziert sein, um die Empfindlichkeit des Sensors zu erhöhen. Die Verringerung der Wandstärke kann insbesondere durch die muldenartige Vertiefung MV gegeben sein.

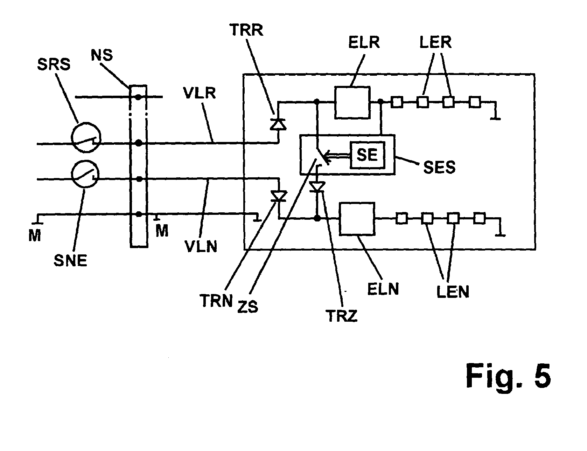

In Fig. 5 ist schematisch eine vorteilhafte Verschaltung für eine Arbeitsleuchte am Heck eines an ein Zugfahrzeug ZF angekoppelten Anhängers AN skizziert. Für die elektrische Verbindung zwischen Zugfahrzeug und Anhänger ist eine genormte Steckverbindung NS eingezeichnet, welche u. a. einen Pol für die Verbindung der elektrischen Massepotentiale M von Zugfahrzeug und Anhänger, einen Pol zur Ansteuerung der Rückfahrscheinwerferfunktion und einen Pol zur Ansteuerung der Nebelschlussleuchtenfunktion enthält. Die weiteren Pole in der mehrpoligen Steckverbindung seien für die weitere Erläuterung der Arbeitsleuchtenfunktion nicht weiter betrachtet.

Der Rückfahrscheinwerfer kann über einen zugfahrzeugseitigen Schalter SRS, welcher typischerweise automatisch bei eingelegtem Rückwärtsgang betätigt ist, eingeschaltet werden, wobei eine Versorgungselektronik ELR im Leuchtengehäuse über eine individuell der Rückfahrscheinwerferfunktion zugeordnete Versorgungsleitung VLR mit elektrischer Leistung aus dem Zugfahrzeug versorgt wird und die Leuchtdioden LER einschaltet und z. B. mit konstantem Strom oder konstanter Spannung beaufschlagt. In entsprechender Weise und unabängig von der Rückfahrscheinwerferfunktion kann mittels eines zugfahrzeugseitigen Schalters SNE die Nebelschlussleuchtenfunktion eingeschaltet werden, wobei über die individuell der Nebelschlussleuchtenfunktion zugeordnete Versorgungsleitung VLN die Versorgungselektronik ELN mit elektrischer Leistung aus dem Zugfahrzeug versorgt wird und die Leuchtdioden LEN der Nebelschlussleuchte mit Konstantstrom beaufschlagt werden. Dioden TRR und TRN sind als Rückwirkungssperren eingefügt.

Für die Funktion der Arbeitsleuchte in der Ausführung als Kombination von Rückfahrscheinwerfer als Basisleuchte und gleichzeitig leuchtender Nebelschlussleuchte als weiterer Lichtquelle der Arbeitsleuchte ist ein berührungslos zu betätigender Sensorschalter SES mit Sensor SE aus der elektrischen Versorgung des Rückfahrscheinwerfers, z. B. am Ausgang der Versorgungseleketronik ELR, mit elektrischer Leistung versorgt und dadurch aktiviert. Wird der Sensorschalter über den Sensor SE betätigt, so schließt dieser ein im Ruhezustand geöffnetes Schaltelement ZS, welches die elektrische Versorgung der Rückfahrscheinwerferfunktion zusätzlich auf die Versorgungselektronik ELN der Nebelschlussleuchte leitet, wobei vorteilhafterweise wiederum eine Rückwirkungssperre TRZ eingefügt ist. Dadurch wurden auch bei offenem Schalter SNE die Leuchtdioden LEN der Nebelschlussleuchte eingeschaltet. Das Schaltelement ZS bleibt geschlossen, bis der Schalter SES erneut betätigt wird, um die Arbeitsleuchtenfunktion auszuschalten.

In vorteilhafter Ausführung kann vorgesehen sein, dass das Schaltelement nur so lange geschlossen bleibt bis der Rückfahrscheinwerfer ausgeschaltet wird. Für ein erneutes Schließen des Schaltelements ZS muss erneut der Sensorschalter SES betätigt werden.

In anderer Ausführung kann vorgesehen sein, dass das Schaltelement über den Sensor des Sensorschalters zwischen einem offenen und einem geschlossenen Zustand umschaltbar ist und in dem jeweiligen Schaltzustand bis zur nächsten Betätigung des Sensorschalters verbleibt, insbesondere auch nach Wegfall der Versorgungsspannung über die Versorgungsleitung VLR des Rückfahrscheinwerfers. Der Sensorschalter selbst ist ohne Spannungsversorgung über die Versorgungsleitung VLR nicht aktiv und kann dabei nicht zum Wechsel des Schaltzustands benutzt werden. Ein unbefugtes Betätigen z. B. an einem abgestellten Fahrzeug ist damit nicht möglich. Wird der Rückfahrscheinwerfer bei eingeschalteter Arbeitsleuchtenfunktion ausgeschaltet, so erlischt auch die zusätzliche Lichtquelle, wenn diese nicht über eine eigene Versorgungsleitung eingeschaltet ist. Das Schaltelement behält aber seinen geschlossenen Schaltzustand bei. Bei erneutem Einschalten des Rückfahrscheinwerfers wird durch das noch geschlossene Schaltelement die zusätzliche Lichtquelle mit eingeschaltet, ohne das es einer Betätigung des Sensorschalters bedarf.

Ist nur die Nebelschlussleuchtenfunktion über den zugfahrzeugseitigen Schalter SNE eingeschaltet, der Schalter SHS aber offen, so ist der Sensorschalter nicht aktiviert und eine Überkopplung von elektrischer Leistung sowohl durch das geöffnete Schaltelement ZS als auch durch die Rückwirkungssperre TRZ ausgeschlossen. Sind beide Schalter SRS und SNE geschlossen, so ist die elektrische Verbindung über das Schaltelement ZS ohne Wirkung und sowohl die Leuchtdioden LER als auch die Leuchtdioden LEN brennen unabhängig von der Schaltstellung des Schaltelements ZS gleichzeitig.

Basisleuchte, insbesondere Rückfahrscheinwerfer, und weitere Leuchte der Arbeitsleuchte, insbesondere Nebelschlussleuchte, sind vorteilhafterweise in demselben Leuchtengehäuse, vorzugsweise auf einer Platine angeordnet. Basisleuchte und weitere Leuchte können aber auch voneinander beabstandet und über Kable verbunden sein. Dabei kann vorteilhafterweise vorgesehen sein, dass Basisleuchte und weitere Leuchte über ein mehradriges Kabel mit eigener Kabelader zu jeder einzelnen Leuchtenfunktion angeschlossen sind und von der Basisleuchte elektrische Leitung in die Kabelader der weiteren Lichtquelle einspeisbar ist.

Die Kopplung der Arbeitsleuchtenfunktion an die Rückfahrscheinwerferfunktion ist besonders vorteilhaft, da hierdurch zuverlässig vermieden wird, dass die Arbeitsleuchtenfunktion im regulären Fahrbetrieb versehentlich eingeschaltet wird oder dass die Arbeitslichtfunktion über den Sensorschalter versehentlich nicht ausgeschaltet wird und unbeabsichtigt im Fahrbetrieb eingeschaltet bleibt.

Vorteilhafterweise kann die Arbeitsleuchtenfunktion obwohl in genormten Verdrahtungen nicht vorgesehen mit den vorhandenen Leitungen als zusätzliche Leuchtenfunktion eingesetzt sein.

Die vorstehend und die in den Ansprüchen angegebenen sowie die den Abbildungen entnehmbaren Merkmale sind sowohl einzeln als auch in verschiedener Kombination vorteilhaft realisierbar. Die Erfindung ist nicht auf die beschriebenen Ausführungsbeispiele beschränkt, sondern im Rahmen fachmännischen Könnens in mancherlei Weise abwandelbar.

## Patentansprüche

1. Heckleuchtenanordnung, insbesondere für Lastfahrzeuge, mit einem Leuchtengehäuse, welches eine transparente Lichtscheibe und ein Bodenteil enthält und einen Innenraum mit einer Lichtquellenanordnung mit Leuchtdioden umgibt, **dadurch gekennzeichnet, dass** das Bodenteil zumindest teilweise, vorzugsweise überwiegend, insbesondere vollständig als ein Spritzgussteil aus einem gefüllten Kunststoff besteht, welcher ein spritzgussfähiges Kunststoff-Grundmaterial und Füllkörper enthält, welche die Wärmeleitfähigkeit erhöhen.

2. Anordnung nach Anspruch 1, **dadurch gekennzeichnet, dass** das Bodenteil topfförmig ausgebildet ist.

3. Anordnung nach Anspruch 1 oder 2, **dadurch gekennzeichnet, dass** das Bodenteil mit der Lichtscheibe eine umlaufende Gehäusefuge bildet.

4. Anordnung nach Anspruch 3, **dadurch gekennzeichnet, dass** die Gehäusefuge mit einem angespritzten Elastomer abgedichtet ist.

5. Anordnung nach einem der Ansprüche 1 bis 4, **dadurch gekennzeichnet, dass** an der Außenseite der die Rückwand bildenden Fläche des Bodenteils eine Reliefstruktur mit von der Rückwand weg weisenden Vorsprüngen ausgebildet ist.

6. Anordnung nach Anspruch 5, **dadurch gekennzeichnet, dass** die Vorsprünge parallele Stege bilden.

7. Anordnung nach Anspruch 5 oder 6, **dadurch gekennzeichnet, dass** der Rückwand abgewandte Enden der Vorsprünge flach ausgeführt sind und in einer gemeinsamen Ebene liegen.

8. Anordnung nach Anspruch 7, **dadurch gekennzeichnet, dass** die Summe der Flächen der abgeflachten Enden der Vorsprünge wenigstens 20 %, insbesondere wenigstens 30 %, vorzugsweise wenigstens 40 % der Fläche der Rückwand beträgt.

9. Anordnung nach Anspruch 7 oder 8, **dadurch gekennzeichnet, dass** die Breite der flachen Enden der Vorsprünge wenigstens 35 %, insbesondere wenigstens 45 %, vorzugsweise wenigstens 60 % deren Höhe über die Rückwand hinaus beträgt.

10. Anordnung nach einem der Ansprüche 5 bis 9, **dadurch gekennzeichnet, dass** die flachen Enden der Vorsprünge gegen eine Metallfläche des Fahrzeugs verspannt.

11. Anordnung nach Anspruch 10, **dadurch gekennzeichnet, dass** die Verspannung über im Bodenteil verankerte Befestigungselemente erfolgt.

12. Anordnung nach einem der Ansprüche 1 bis 11, **dadurch gekennzeichnet, dass** die Innenwand der Rückwand überwiegend flach ist und dass zwischen eine oder mehrere die Leuchtdioden tragende Schaltungsplatine eine Wärmespreizschicht aus gut wärmeleitendem Material eingefügt ist.

13. Heckkleuchtenanordnung, insbesondere für Lastfahrzeuge mit einer im Bereich der Fahrzeugrückleuchte angeordneten Arbeitsleuchte, welche ein Leuchtengehäuse mit einem Gehäuseboden und einer Lichtscheibe aufweist, wobei innerhalb des Leuchtengehäuses ein Sensorschalter angeordnet ist, welcher berührungslos durch die Lichtscheibe hindurch zum Einschalten der Arbeitsleuchte betätigbar ist.

14. Anordnung nach Anspruch 13, **dadurch gekennzeichnet, dass** die Wandstärke der Lichtscheibe im Bereich des Sensorschalters gegenüber der Umgebung geringer ist.

15. Anordnung nach Anspruch 13 oder 14, **dadurch gekennzeichnet, dass** an der Außenfläche der Lichtscheibe eine tastbare Reliefstruktur ausgebildet ist.

16. Anordnung nach Anspruch 15, **dadurch gekennzeichnet, dass** die tastbare Reliefstruktur eine muldenförmige Vertiefung umfasst.

17. Heckleuchtenanordnung, insbesondere für Lastfahrzeuge, welche einen im wesentlichen weißes Licht abgebenden Rückfahrscheinwerfer und ein rotes Licht abgebende Nebelschlussleuchte enthält, **dadurch gekennzeichnet, dass** Rückfahrscheinwerfer und Nebelschlussleuchte Leuchtdioden als lichtemittierende Elemente besitzen und in einem gemeinsamen Leuchtengehäuse angeordnet sind, und dass das Leuchtengehäuse eine für Rückfahrscheinwerfer und Nebelschlussleuchte gemeinsame transparente Lichtscheibe besitzt.

18. Anordnung nach Anspruch 17, **dadurch gekennzeichnet, dass** die Lichtscheibe einheitlich farblos transparent ist.

19. Anordnung nach Anspruch 17 oder 18, **dadurch gekennzeichnet, dass** die Leuchtdioden für Rückfahrscheinwerfer einerseits und für Nebelschlussleuchte andererseits getrennte, nicht überlappende Flächenbereiche hinter der Lichtschiebe einnehmen.

20. Heckleuchtenanordnung, insbesondere für Lastfahrzeuge, mit einer weißes Licht abgebenden Rückfahrscheinwerfer und/oder einer rotes Licht abgebenden Nebelschlussleuchte, **dadurch gekennzeichnet, dass** eine heckseitigen Arbeitsleuchte mit höherer Lichtleistung als Rückfahrscheinwerfer oder Nebelschlussleuchte vorgesehen ist und dass Rückfahrscheinwerfer und/oder Nebelschlussleuchte als Teil der Arbeitsleuchte eingesetzt sind.

21. Anordnung nach Anspruch 20, **dadurch gekennzeichnet, dass** ein separater Schalter zum Einschalten der Arbeitsleuchte vorgesehen ist.

22. Anordnung nach Anspruch 20 oder 21, **dadurch gekennzeichnet, dass** der Rückfahrscheinwerfer eine Basisleuchte der Arbeitsleuchte bildet und diese eine zuschaltbare weitere Lichtquelle enthält.

23. Anordnung nach Anspruch 22, **dadurch gekennzeichnet, dass** die weitere Lichtquelle nur bei eingeschaltetem Rückfahrscheinwerfer zuschaltbar ist.

24. Anordnung nach Anspruch 22, **dadurch gekennzeichnet, dass** die weitere Lichtquelle über die elektrische Versorgungsleitung für den Rückfahrscheinwerfer betreibbar ist.

25. Anordnung nach einem der Ansprüche 20 bis 22, **dadurch gekennzeichnet, dass** die Arbeitsleuchte durch Rückfahrscheinwerfer als Basisleuchte und gleichzeitig eingeschaltete Nebelschlussleuchte als weitere Lichtquelle gebildet ist.

26. Heckleuchtenanordnung nach wenigstens zweien der Ansprüche 1, 13, 17 oder 20.
